# EUROPÄISCHE PATENTSCHRIFT

(11) **EP 1 114 201 B1**
(45) Veröffentlichungstag und Bekanntmachung des Hinweises auf die Patenterteilung: **28.01.2004**
(21) Anmeldenummer: 99942801.4
(22) Anmeldetag: 28.07.1999
(51) Int. Cl.: C23C 14/34

(54) **VORRICHTUNG UND VERFAHREN ZUR PLASMABEHANDLUNG VON GEGENSTÄNDEN IM VAKUUM**
DEVICE AND METHOD FOR THE VACUUM PLASMA PROCESSING OF OBJECTS
DISPOSITIF ET PROCEDE POUR LE TRAITEMENT AU PLASMA D'ARTICLES SOUS VIDE

(30) Priorität: 31.07.1998 DE 19834733
(43) Veröffentlichungstag der Anmeldung: 11.07.2001
(73) Patentinhaber: Fraunhofer-Gesellschaft zur Förderung der angewandten Forschung e.V., 80686 München (DE)
(72) Erfinder: JUNG, Thomas, D-38173 Hötzum (DE)
(74) Vertreter: Pfenning, Meinig & Partner GbR
(86) Internationale Anmeldenummer: PCT/EP1999/005409
(87) Internationale Veröffentlichungsnummer: WO 2000/008227

(56) Entgegenhaltungen:
- US-A- 3 282 816
- US-A- 4 090 941
- US-A- 5 277 779
- PATENT ABSTRACTS OF JAPAN vol. 1998, no. 01, 30. Januar 1998 (1998-01-30) & JP 09 241824 A (HITACHI LTD;HITACHI INF TECHNOL:KK), 16. September 1997 (1997-09-16)

## Beschreibung

Die Erfindung betrifft eine Vorrichtung und ein Verfahren zur Plasmabehandlung von Gegenständen im Vakuum unter Verwendung eines Plasmas, wobei die Möglichkeit besteht, vielgestaltige Gegenstände allseitig zu beschichten bzw. zu modifizieren, ohne daß ein großer anlagentechnischer bzw. verfahrenstechnischer Aufwand erforderlich sind. Neben der Beschichtung bzw. Modifizierung zur Verbesserung, z.B. der Haftfestigkeit von gegebenenfalls nachträglich aufzubringenden Beschichtungen kann auch ein Reinigen, Ätzen und/oder Aktivieren ohne weiteres durchgeführt werden.

Neben der Modifizierung von oberflächennahen Bereichen von Gegenständen können mit der Erfindung insbesondere mikroskopisch dichte Metallschichten oder Verbindungsschichten, die eine kleine Rauhigkeit aufweisen, aufgebracht werden.

Das Auftragen von Beschichtungen auf Gegenständen ist von G.Kienel; Vakuumbeschichtung, Band 2; VDI-Verlag GmbH Düsseldorf 1993; Seiten 160 - 161; unter Verwendung eines planaren Gleichspannungs-Magnetrons bekannt.

Die US 3 282 816 beschreibt ein Beschichtungsverfahren, das auf einem Sputtervorgang beruht, wobei die Elektroden und das damit verbundene magnetische Feld so ausgerichtet ist, daß eine möglichst hohe Abscheidungseffizienz erzielt wird.

Die US 4 090 941 beschreibt ein Verfahren und eine Apparatur zur Beschichtung von Substraten mit einer Kathoden-Sputter-Technik.

Eine solche Lösung, ermöglicht aber nur bedingt eine (räumliche in 3 Dimensionen vorzunehmende Beschichtung von Gegenständen, wenn diese gleichzeitig bewegt werden, was insbesondere in hierfür erforderlichen Vakuumkammern, wenn überhaupt, nur schwer und sehr aufwendig realisierbar ist. Weisen solche Gegenstände Hinterschneidungen auf, können diese normalerweise nicht beschichtet werden.

Außerdem müssen schädliche Restgaseinflüsse durch Erzeugung eines Hochvakuums vermieden werden, was entweder die Zeit für die Erzeugung des Vakuums stark erhöht, teure Vakuumschleusen oder teure Hochvakuumpumpen erfordert.

Ein weiterer Nachteil besteht darin, daß größere Flächen parasitär beschichtet werden, was zu hohen Beschichtungsmaterialverlusten führt, die sich insbesondere bei kostenintensiven Beschichtungsmaterialien, wie z.B. Edelmetallen negativ auswirken. Zusätzlich entsteht ein erhöhter Reinigungsaufwand durch die parasitären Beschichtungen in der Kammer und dort befindlichen Elemente.

Die Menge an Beschichtungsmaterial, das auf die entsprechenden Gegenstände aufgebracht werden kann, ist entsprechend begrenzt, so daß für erforderliche Targetwechsel eine relativ häufige Unterbrechung des Beschichtungsprozesses nötig ist.

Aus US 3 282 816 ist ein Sputter-Verfahren mit einer zylindrischen Hohlkathode bekannt. Dabei werden zu beschichtende Gegenstände im Zentrum der zylindrischen Hohlkathode angeordnet und beim Sputter-Verfahren auftretende Elektronen und Ionen mit Hilfe eines von der Außenseite der zylindrischen Hohlkathode angelegten Magnetfeldes, in deren Inneren gezielt bewegt.

Die obere und untere Stirnseite der zylindrischen Hohlkathode sind bei dieser bekannten Lösung, durch elektrisch nicht leitende, plattenförmige Elemente weitestgehend verschlossen, wobei in diesen Elementen Zu- und Abführungen für Gase sowie an einer Stirnseite eine Durchführung für eine Anode angeordnet sind.

Aus US 4 090 941 ist eine Vorrichtung zum Sputtern bekannt, bei der ebenfalls eine zylindrische Hohlkathode eingesetzt wird. Diese Hohlkathode kann in einer Vakuumkammer angeordnet werden, die über Gaszuund -abflüsse verfügt und an der ebenfalls über Spulen von außen ein Magnetfeld angelegt wird. Im Inneren dieser zylindrischen Hohlkathode ist eine zusätzliche Kathode angeordnet und die zu beschichtenden Gegenstände sind während des Beschichtungsvorgangs im Zwischenraum zwischen der zentralen Kathode und der zylindrischen Hohlkathode angeordnet.

Es ist daher Aufgabe der Erfindung, eine Vorrichtung und ein entsprechendes Verfahren vorzuschlagen, mit dem eine Oberflächenmodifizierung und/oder Beschichtung verschiedenst gestalteter Gegenstände an allen Seiten und gegebenenfalls auch auf hinterschnittenen Flächenbereichen mit geringem anlagentechnischem, verfahrenstechnischem und Kostenaufwand erreichbar ist.

Erfindungsgemäß wird diese Aufgabe mit den Merkmalen des Anspruchs 1 für die Vorrichtung und den Merkmalen des Anspruchs 10 für das Verfahren gelöst. Vorteilhafte Ausgestaltungsformen und Weiterbildungen der Erfindung ergeben sich durch die Anwendung, der in den untergeordneten Ansprüchen genannten Merkmale. Die erfindungsgemäße Vorrichtung kann für die bereits eingangs in der Beschreibung genannte Beschichtung von Gegenständen mit Metallen, Metall-Legierungen oder verschiedenen Metallverbindungen, wie Metallnitride bzw. Metalloxide bzw. alternativ und kommulativ hierzu an den Oberflächen entsprechend modifiziert werden, so daß beispielsweise die Haftungseigenschaften für nachfolgend aufzubringende Beschichtungen verbessert werden können. Dabei wird ein kastenförmiges Gebilde, das beispielsweise die Form eines Rechteckes, Kubuses oder eines Zylinders aus einem elektrisch leitenden Material aufweist, verwendet. Das kastenförmige Gebilde kann für sich gesehen eine Vakuumkammer darstellen, die durch Anschluß entsprechender Pumpen und Ventile in Verbindung, mit noch nachfolgend zu nennenden technischen Elementen verwendet wird. Es besteht aber auch die Möglichkeit, ein solches kastenförmiges Gebilde in eine herkömmliche Vakuumkammer einzusetzen und dort erfindungsgemäß zu arbeiten.

Die zu beschichtenden bzw. modifizierenden Gegenstände werden in das Innere des kastenförmigen Gebildes eingesetzt und zwar so, daß ein direkter Kontakt zwischen den Gegenständen und der Innenwandung vermieden und ansonsten eine elektrische Isolierung als Träger für die Gegenstände verwendet wird. Die Gegenstände können bevorzugt über verschließbare Öffnungen in das kastenförmige Gebilde eingesetzt werden, so daß die Gegenstände allseitig umschlossen sind. Das kastenförmige Gebilde kann aber auch aus zwei Teilen bestehen, wobei ein Teil einen Deckel bildet, der auf das Unterteil aufsetzbar ist.

Zumindest die Innenwandung sollte aus einem für die Beschichtung geeigneten Material bestehen. Selbstverständlich kann aber auch das gesamte kastenförmige Gebilde aus einem für die Beschichtung geeigneten Material gebildet sein oder an den Innenwandungen des kastenförmingen Gebildes können flächige Targets aus einem Beschichtungsmaterial angeordnet werden.

Außerdem sind Öffnungen für die Zu- und Abführung von Arbeitsgas sowie mindestens eine Öffnung, durch die Energie zur Erzeugung einer Glimmentladung, in das das kastenförmige Gebilde eingeführt werden kann, erforderlich.

Für die Modifizierung bzw. Beschichtung wird das kastenförmige Gebilde gegenüber dem mit der Glimmentladung erzeugten Plasma auf ein elektrisch negatives Potential gelegt.

Die durch eine Glimmentladung hervorgerufene Plasmaerzeugung kann auf verschiedene Art und Weise erfolgen. Hierfür besteht einmal die Möglichkeit, durch eine Öffnung eine Elektrode in das Innere des kastenförmigen Gebildes einzuführen, an die eine Gleichoder Wechselspannung angelegt wird. Bei Anlegung einer Gleichspannung ist die Elektrode als Anode geschaltet. Die entsprechend angelegte Wechselspannung kann nieder-, mittel- bzw. hochfrequent sein.

Eine alternative Möglichkeit zur Erzeugung des Plasmas besteht darin, durch eine Öffnung Mikrowellen in das Innere des kastenförmigen Gebildes zu richten und damit das Plasma zu erzeugen.

Da das kastenförmige Gebilde gegenüber dem Plasma ein negatives elektrisches Potential aufweist, kann an der inneren Oberfläche durch Auftreffen energiereicher, positiver Ionen aus dem Plasma Material abgetragen werden (Kathodenzerstäubung), das sich dann auf den Gegenständen niederschlägt. Hierfür muß jedoch eine ausreichende Potentialdifferenz eingestellt werden. Für den Fall, daß eine entsprechende Potentialdifferenz nicht erreicht worden ist, wird kein bzw. nahezu kein Material abgetragen und es erfolgt lediglich eine Modifizierung im oberlfächennahen Bereich der im kastenförmigen Gebilde aufgenommenen Gegenstände. Die Gegenstände können aus den verschiedensten Materialien, wie z.B. Metall, Kunststoff oder Keramik bestehen.

Durch einfache Erhöhung der Potentialdifferenz zwischen kastenförmigem Gebilde und Plasma kann im Nach gang zur Modifizierung die Beschichtung der Gegenstände eingeleitet werden. Durch den entsprechenden Materialabtrag an allen Innenwänden des kastenförmigen Gebildes ist eine allseitige Beschichtung von beliebig dreidimensional geformten Gegenständen, ohne zusätzliche Manipulation der Gegenstände möglich und es können auch Hinterschneidungen beschichtet werden, wobei sich hier ein erhöhter Arbeitsdruck, der zur gestreuten Verteilung der abgetragenen Materialbestandteile führt, positiv auswirkt. Es kann also eine gleichförmige und nahezu gleichzeitige Modifizierung und/oder Beschichtung von Gegenständen erreicht werden.

Das Beschichtungsmaterial, das nicht direkt auf der Oberfläche der Gegenstände abgeschieden wird, schlägt sich im wesentlichen wieder an der inneren Oberfläche des kastenförmigen Gebildes nieder und geht so dem Beschichtungsprozeß nicht verloren. Da Streubeschichtungen nur auf relativ kleinformatige Einbauten im kastenförmigen Gebilde, wie beispielsweise einem Träger, auf dem die Gegenstände gehalten sind, sich absetzen, verringert sich der Reinigungsaufwand gegenüber herkömmlichen Lösungen beträchtlich.

Den sich bekanntermaßen in solchen Prozessen bildende Adsorbatschichten, die durch Desorption bei Vakuumbeschichtungsprozessen durch ihre Desorption während der Beschichtung, die Schichtqualität und die Schichthaftung nachteilig beeinflussen, kann sehr effektiv durch Ionenbeschußentfernung entgegengewirkt werden. Hierfür kann das Innere des kastenförmigen Gebildes vor der eigentlichen Beschichtung relativ kurzzeitig mit geringer Plasmaleistung, geringerem negativen Potential am kastenförmigen Gebilde und/ oder durch Beaufschlagung mit einem erhöhten Arbeitsdruck gereinigt werden, so daß für die Entfernung der Adsorbatschichten keine zusätzlichen technischen Erfordernisse getroffen werden müssen und das Adsorbat nach dem Ablösen ohne weiteres mit dem Arbeitsgas abgesaugt werden kann.

Bei der erfindungsgemäßen Vorrichtung besteht auch die Möglichkeit, einen großen Teil der Adsorbatschichten bereits vor dem Auslösen der Glimmentladung und Plasmaerzeugung mit dem Einleiten und Absaugen von sauberem, trockenen Arbeitsgas bereits während der Evakuierungsphase zu entfernen. Hierzu wird relativ wenig Arbeitsgas benötigt, da das kastenförmige Gebilde und dessen innere Oberfläche, im Vergleich zur inneren Oberfläche herkömmlicher Vakuumbeschichtungskammern, bei gleichem Volumen der zu beschichtenden Gegenstände, relativ klein sein kann.

Durch den Ionenbeschuß kann die innere Oberfläche des kastenförmigen Gebildes auf einfache Art und Weise und ohne zusätzlichen technischen Aufwand erwärmt werden, so daß die Desorption der Adsorbatschichten erheblich beschleunigt werden kann.

Für den Fall, daß das kastenförmige Gebilde in eine größer formatige Vakuumkammer eingesetzt worden ist und demzufolge nicht selbst als Vakuumkammer wirkt, bleibt der Effekt erhalten, da die Gasströmung im kastenförmigen Gebilde durch den relativ kleinen freien Querschnitt seiner Öffnungen keine desorbierten Gase von der Wandung der größeren Vakuumkammer in das kastenförmige Gebilde eindringen läßt.

Da die Reinigung des Innenraumes des kastenförmigen Gebildes von Adsorbatschichten durch Ionenbeschuß und Gasströmung sehr wirksam ist, und der erforderliche Arbeitsdruck während der eigentlichen Beschichtung im Bereich des Grob-/Feinvakuums liegt, ist keine Hochvakuumpumpe mit entsprechend hohem Kostenaufwand erforderlich.

Gegenüber der bekannten Lösung der Beschichtung mit Magnetronquellen bietet die erfindungsgemäße Lösung einen weiteren Vorteil, der darin besteht, daß wesentlich mehr Beschichtungsmaterial zur Verfügung steht, als dies bei den dort zu verwendenden Targets der Fall ist. Da die gesamte innere Oberfläche des kastenförmigen Materials aus Beschichtungsmaterial besteht oder dort entsprechend dimensionierte flächige Targets aus einem solchen Beschichtungsmaterial angeordnet sind, ist der Beschichtungsmaterialvorrat wesentlich größer und der Prozeß muß entsprechend seltener für eine Nachbeschickung mit Beschichtungsmaterial unterbrochen werden. Außerdem verändern sich dadurch auch bei starkem Abtrag von Beschichtungsmaterial die Plasmaparameter nicht unzulässig. Außerdem kommt es nicht zu einer Begrenzung durch den von einer großen Dicke der Targets hervorgerufenen Wärmewiderstand.

Das kastenförmige Gebilde kann in Verbindung mit dem Druck des Arbeitsgases so dimensioniert werden, daß die infolge der eingebrachten Energie hervorgerufene Entladung den Charakter einer Hohlkathoden-Glimmentladung trägt, so daß eine besonders hohe Plasmadichte und demzufolge eine große Beschichtungsrate erreicht werden kann, ohne daß teure Permanentmagneten, wie bei der Verwendung von Magnetronen, erforderlich sind. Dabei kann die von M. v. Ardenne in "Effekte der Physik"; Verlag Harry Deutsch; Thun, Frankfurt/-Main; 1990 genannte Bedingung Druck Rohr-Innendurchmesser = 133,3 Pa cm mit einem Toleranzbereich maximal 13,33-133,3 Pa cm für die Entstehung einer Hohlkathodenentladung entsprechend berücksichtigt werden, wenn für den Rohr-Innendurchmesser die jeweilige lichte Weite des kastenförmigen Gebildes gesetzt wird.

Da erfindungsgemäß die Modifizierung und Beschichtung bei relativ niedrigen Temperaturen durchgeführt werden kann, besteht außerdem die Möglichkeit und es wirkt sich günstig aus, das kastenförmige Gebilde mit einer Kühlung, bevorzugt Wasserkühlung auszustatten.

Wie bereits erwähnt, kann die Potentialdifferenz zwischen dem erzeugten Plasma und dem kastenförmigen Gebilde definiert beeinflußt werden und im Bereich zwischen 100 bis 1000 V eingestellt werden. Dabei genügen die kleineren Spannungswerte für die Modifizierung und die höheren Spannungswerte sind für das Aufbringen einer Beschichtung erforderlich.

Der Druck im kastenförmigen Gebilde kann im Bereich zwischen 10⁻³ bis 10 mbar definiert eingestellt werden.

Die Absaugöffnung für das Arbeitsgas hat eine Größe zwischen einigen cm² bis ca. 100 cm² und es ist günstig, die anderen Öffnungen im kastenförmigen Gebilde so zu dimensionieren, daß deren Summe kleiner als die Größe der Absaugöffnung ist.

Das kastenförmige Gebilde kann eine lichte Weite im Bereich zwischen 1 cm und 1 m aufweisen und sollte mindestens die 1,2-fache Größe der Gegenstände aufweisen und maximal 10-fach so groß sein. Die Gegenstände, die modifiziert bzw. beschichtet werden sollen, sollten im Inneren des kastenförmigen Gebildes ein Volumen von etwa 0,1 % bis 30 % ausfüllen. Die Gegenstände im kastenförmigen Gebilde sollten von diesem elektrisch isoliert auf z.B. einem oder mehreren Trägern gehalten sein und zur Innenwandung des kastenförmigen Gebildes einen Abstand von mindestens 0,1 bis maximal 10 cm aufweisen.

Als Beschichtungsmaterial kommen verschiedene Metalle, wie z.B. Kupfer, Aluminium, Titan oder Legierungen davon zum Einsatz. Es können aber auch Metallverbindungen, wie z.B. Titannitrid oder Indium-Zinn-Oxid verwendet werden.

Das Arbeitsgas kann insbesondere für die Spülung und Reinigung ein sauberes, trockenes Inertgas, z.B. Argon sein. Für die Beschichtung kann jedoch ein Arbeitsgasgemisch, aus einem Inertgas und einem Reaktivgas verwendet werden. Ein solches Arbeitsgasgemisch ist z.B. Argon und Stickstoff, so daß Nitridschichten auf den Gegenständen abgeschieden werden können.

Der Gasfluß kann mit mindestens 10 Norm cm³/min (Norm Kubikzentimeter pro Minute) und maximal 1000 Norm cm³/min eingestellt werden.

Für den Fall, daß nur eine sehr geringe Beschichtung oder keine Beschichtung aufgebracht werden soll, sollte die Potentialdifferenz zwischen dem Plasma und dem kastenförmigen Gebilde unterhalb 200 V eingestellt und/oder der Druck um mindestens den Faktor drei erhöht werden. Bei einer solchen Einstellung kann eine Oberflächenmodifizierung, wie bereits allgemein erwähnt, durchgeführt werden.

Die erfindungsgemäße Vorrichtung kann auch zur Erzeugung von Kompositstruktur verwendet werden. Dazu ist vorgesehen, daß durch eine der vorhandenen Öffnungen oder durch ein eigens dafür eingebrachte Öffnung Feststoffpulver zugeführt wird. Es ist auch möglich, das Feststoffpulver in einem Behältnis in der Vorrichtung unterzubringen. Die Partikel des Feststoffpulvers weisen bevorzugt eine Größe von 10⁻⁴ bis 10⁻⁹ m auf. Als Feststoffpartikel kommen grundsätzlich alle bekannten Hartstoffe in Frage. Beispiele sind hochschmelzende Metalloxide wie Korund oder Titanoxid. Auch Diamantgraphit oder Nitride können eingesetzt werden. Verfahrensgemäß wird bei Einbringung des Pulvers über eine Öffnung das Pulver dem Inertgasstrom zugemischt. Sofern das Pulver in einem Behältnis untergebracht ist, erfolgt eine automatische Verwirbelung durch das angelegte Vakuum. Die Partikel lagern sich dann auf der zu beschichtenden Oberfläche ab.

Nachfolgend soll die Arbeitsweise gemäß der Erfindung erst in allgemeiner Form und anschließend an zwei konkreten Beispielen näher beschrieben werden.

Nach dem Einbringen der Gegenstände in das kastenförmige Gebilde, wird mittels einer Vakuumpumpe die Evakuierung des kastenförmigen Gebildes bzw. der diese umschließenden Vakuumkammer durchgeführt und gleichzeitig bzw. kurz danach folgend ein Spülen mit Arbeitsgas durchgeführt.

Ist ein ausreichend kleiner Druck (1 bis 10 mbar) erreicht, wird das kastenförmige Gebilde auf ein gegenüber dem Plasma negatives Potential gelegt und die Glimmentladung durch Energiezufuhr gezündet. Dadurch erfolgt die ionenunterstützte Desorption der Adsorbatschichten.

Nach ausreichender Reinigung wird der Druck durch Reduzierung der Arbeitsgaszufuhr auf einen Druck im Bereich zwischen 0,001 bis 1 mbar abgesenkt und die Potentialdifferenz zwischen kastenförmigem Gebilde und Plasma erhöht. Dies kann z.B. durch Erhöhung des negativen Potentials, also einer höheren negativen Spannung, die am kastenförmigen Gebilde anliegt, erfolgen. Dadurch erfolgt ein Materialabtrag des Beschichtungsmaterials von der Innenwandung des flächigen Gebildes und die in diesem befindlichen Gegenstände werden entsprechend beschichtet. Je nach aufzubringender Beschichtung kann hier reines Inertgas oder ein Inertgas-Reaktivgasgemisch als Arbeitsgas verwendet werden. Der Anteil an Reaktivgas muß jedoch entsprechend des gewünschten Schichtaufbaus eingestellt werden.

Nachfolgend kann die Glimmentladung gelöscht, die Arbeitsgaszufuhr und die Pumpe abgeschaltet und die Vakuumkammer bzw. das kastenförmige Gebilde geflutet werden und nach Öffnung die modifizierten bzw. beschichteten Gegenstände entnommen werden.

Mit den nachfolgenden Beispielen 1 und 2 soll einmal die Beschichtung von Gegenständen mit Kupfer und zum anderen mit Titannitrid konkreter beschrieben werden.

### Beispiel 1

Die Gegenstände werden in das kastenförmigen Gebilde eingebracht, das eine Rohrform hat, sich in einem Vakuumgefäß befindet und aus massivem Kupfer besteht. Zur Evakuierung des Vakuumgefäßes wird die Vakuumpumpe eingeschaltet. Gleichzeitig wird Argon mit ca. 100 Norm cm³/min (Norm Kubikzentimeter pro Minute) zum Spülen eingelassen.

Bei Erreichen eines Druckes von 5 mbar wird das kastenförmige Gebilde auf ein negatives Potential von 300 V gegenüber einer in das kastenförmige Gebilde eingetauchten stabförmigen Anode gelegt und die Glimmentladung gezündet. Das bewirkt die ionenunterstützte Desorption der Adsorbatschichten von der Innenwand des kastenförmigen Gebildes.

Nach ausreichender Reinigung wird der Druck durch Reduzierung der Gaszufuhr auf den Arbeitsdruck von 0,5 mbar abgesenkt und das Potential des kastenförmigen Gebildes auf -500 V eingestellt, wodurch eine Beschichtung der Gegenstände mit Kupfer stattfindet.

Nach 10 min Beschichtungsdauer wird die Glimmentladung durch Abschalten der Stromzufuhr gelöscht und die Argonzufuhr abgestellt. Die Pumpe wird ausgeschaltet und das kastenförmigen Gebilde wird belüftet. Vakuumgefäß und kastenförmiges gebilde werden geöffnet und die beschichteten Gegenstände werden entnommen.

### Beispiel 2

Die Gegenstände werden in das kastenförmige Gebilde eingebracht. Der Kasten hat eine Quaderform, besteht aus Aluminium und stellt selbst das Vakuumgefäß dar, das auf seiner Innenseite nahezu vollständig mit Titanblechen ("Targets") bedeckt ist. Das kastenförmige Gebilde weist in seiner Wand einen kurzen Rohrstutzen auf, an dem eine Mikrowellenquelle angeschlossen ist.

Zur Evakuierung des Kastens wird die Vakuumpumpe eingeschaltet. Kurz danach wird Argon mit ca. 300 Norm cm³/min zum Spülen eingelassen. Bei Erreichen eines Druckes von 10 mbar wird das kastenförmige Gebilde auf ein negatives Potential von 250 V gelegt und die Glimmentladung durch Einschalten der Mikrowellenquelle gezündet.

Nach 3 min Reinigung wird der Druck durch Reduzierung der Gaszufuhr auf 0,3 mbar abgesenkt, und die Gegenstände werden mit einem Potential von -500 V beaufschlagt, wodurch eine Oberflächenreinigung erfolgt. Anschließend wird dem Argon 10 % Stickstoff beigefügt und das Potential des kastenförmigen Gebildes auf - 600 V eingestellt, wodurch eine Beschichtung der Gegenstände mit Titannitrid stattfindet.

Nach 15 min Beschichtung wird die Glimmentladung gelöscht und die Arbeitsgaszufuhr abgestellt. Die Pumpe wird durch ein Ventil abgesperrt und der Kasten wird belüftet. Der Kasten wird geöffnet und die Gegenstände werden entnommen.

Nachfolgend soll der Aufbau von möglichen Beispielen für eine erfindungsgemäße Vorrichtung näher beschrieben werden.

Dabei zeigen:
- Figur 1: ein Beispiel einer erfindungsgemäßen Vorrichtung mit einer eingeführten Elektrode zur Plasmaerzeugung und
- Figur 2: ein zweites Beispiel einer erfindungsgemäßen Vorrichtung mit einer Öffnung, durch die Mikrowellen zur Plasmaerzeugung gerichtet werden können.

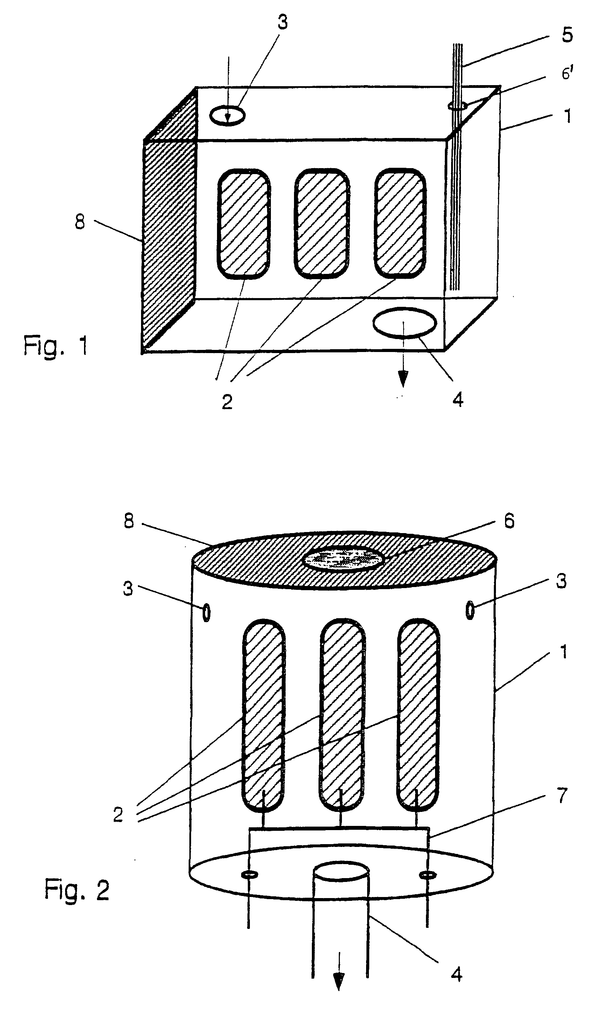

In der Figur 1 ist ein kastenförmiges Gebilde 1 mit rechteckigem Querschnitt dargestellt. Eine Stirnfläche 8 ist dabei als Öffnung ausgebildet, durch die die Gegenstände 2 eingeführt und wieder entnommen werden können. Die Öffnung 8 kann, wie dargestellt, wieder verschlossen werden. Durch die Öffnung 3 kann Arbeitsgas in das flächige Gebilde 1 eingeführt und durch die größer ausgeführte und diametral angeordnete Öffnung 4 wieder abgeführt werden.

Die in diesem Fall als Anode geschaltete Elektrode 5 wird über eine weitere Öffnung 6' eingeführt. Zwischen Anode 5 und kastenförmigem Gebilde 1 ist eine nicht dargestellte Isolierung vorhanden, so daß die Potentiale voneinander getrennt sind.

In der Figur 2 ist ein zylinderförmiges kastenförmiges Gebilde 1 dargestellt, in dem wieder mehrere Gegenstände 2 auf einem gegenüber dem kastenförmigen Gebilde 1 isolierten Träger 7 angeordnet sind. Die obere Stirnfläche ist wiederum als Deckel 8, der entfernt und wieder aufgesetzt werden kann, ausgebildet.

Im Deckel 8 ist eine Öffnung 6 vorhanden, durch die Mikrowellen in das Innere des kastenförmigen Gebildes 1 gerichtet werden können und ein Plasma erzeugt werden kann.

Bei diesem Beispiel sind in der äußeren Mantelfläche zwei Öffnungen 3 vorhanden, durch die Arbeitsgas in das Innere des kastenförmigen Gebildes 1 geführt werden kann. Das Gas kann durch die Öffnung 4, das bei diesem Beispiel mit einem Stutzen verbunden ist, aus dem kastenförmigen Gebilde 1 abgezogen werden.

## Patentansprüche

1. Vorrichtung zur Plasmabehandlung von Gegenständen im Vakuum, bei der
- ein kastenförmiges Gebilde (1) aus einem elektrisch leitenden Material, eine Vakuumkammer bildet oder in eine Vakuumkammer einführbar ist,
- in das gegenüber dem kastenförmigen Gebilde (1) elektrisch isoliert und vom kastenförmigen Gebilde (1) allseitig umschlossene Gegenstände (2) durch mindestens eine verschließbare Öffnung (8) in das kastenförmige Gebilde (1) in einem Abstand zur inneren Wandung eingesetzt sind;
- mindestens eine Öffnung (3) zur Zu- und mindestens eine Öffnung (4) zur Abfuhr von Arbeitsgas sowie eine Öffnung (6, 6') zur Einführung von Energie für die Erzeugung einer Glimmentladung vorhanden sind;
- und das kastenförmige Gebilde (1) ein gegenüber dem mit der Glimmentladung erzeugten Plasma elektrisch negatives Potential aufweist.

2. Vorrichtung nach Anspruch 1, **dadurch gekennzeichnet, daß** durch eine Öffnung (6') eine Elektrode (5) in das kastenförmige Gebilde (1) hineinragt, an der eine Gleich- oder Wechselspannung zur Plasmaerzeugung angelegt ist.

3. Vorrichtung nach Anspruch 1, **dadurch gekennzeichnet, daß** durch die Öffnung (6) Mikrowellen zur Plasmaerzeugung in das Innere des kastenförmigen Gebildes gerichtet sind.

4. Vorrichtung nach einem der Ansprüche 1 bis 3, **dadurch gekennzeichnet, daß** die Gegenstände (2) mit einem vorgebbaren elektrischen Potential beaufschlagt sind.

5. Vorrichtung nach einem der Ansprüche 1 bis 4, **dadurch gekennzeichnet, daß** die Innenwandung des oder das kastenförmige Gebilde (1) aus einem Beschichtungsmaterial gebildet oder als flächiges Target dort angeordnet ist.

6. Vorrichtung nach einem der Ansprüche 1 bis 5, **dadurch gekennzeichnet, daß** das kastenförmige Gebilde (1) gekühlt ist.

7. Vorrichtung nach einem der Ansprüche 1 bis 6, **dadurch gekennzeichnet, daß** die lichte Weite des kastenförmigen Gebildes (1) mindestens die 1,2-fache Größe der Gegenstände (2) und die Gegenstände (2) den zur Verfügung stehenden Raum im kastenförmigen Gebilde (1) mit 0,1 % bis 30 % ausfüllen.

8. Vorrichtung nach einem der Ansprüche 1 bis 7, **dadurch gekennzeichnet, daß** die Größe der Absaugöffnung (5) größer als die Summe der größeren der anderen Öffnungen (3, 6, 6') des kastenförmigen Gebildes (1) ist.

9. Vorrichtung nach einem der Ansprüche 1 bis 8, **dadurch gekennzeichnet, daß** das kastenförmige Gebilde (1) oder dessen innere Oberfläche aus einem Metall, einer Metall-Legierung oder einer Metallverbindung besteht.

10. Verfahren zur Plasmabehandlung von Oberflächen von Gegenständen, mit einer Vorrichtung nach einem der Ansprüche 1 bis 9,
**dadurch gekennzeichnet, daß** nach Evakuierung auf einen ausreichend niedrigen Druck und Spülung mit einem Arbeitsgas im aus einem elektrisch leitenden Material bestehenden kastenförmigen Gebilde (1) ein Plasma erzeugt wird, wobei die Plasmaleistung und das negative Potential des kastenförmigen Gebildes (1) so eingestellt werden, daß eine Modifizierung der Oberfläche und/oder durch Materialabtrag von der Innenwandung des kastenförmigen Gebildes (1) eine Beschichtung der Oberfläche der allseitig vom kastenförmigen Gebilde (1) umschlossenen Gegenstände (2) durchgeführt wird.

11. Verfahren nach Anspruch 10, **dadurch gekennzeichnet, daß** vor der Modifizierung oder Beschichtung bei angelegtem negativen Potential am kastenförmigen Gebilde (1) und gezündeter Glimmentladung eine ionengestützte Desorption abgesetzter Adsorbatschichten durchgeführt wird.

12. Verfahren nach Anspruch 10 oder 11, **dadurch gekennzeichnet, daß** während der Beschichtung Reaktivgas zugeführt wird.

13. Verfahren nach einem der Ansprüche 10 bis 12, **dadurch gekennzeichnet, daß** Feststoffpulver in das kastenförmige Gebilde zugeführt und/oder in einen dort angeordneten Behältnis bereitgestellt und das Feststoffpulver auf die Oberfläche (2) der Gegenstände abgeschieden wird.

14. Verfahren nach einem der Ansprüche 10 bis 13, **dadurch gekennzeichnet, daß** die Potentialdifferenz zwischen kastenförmigem Gebilde (1) und Plasma im Bereich zwischen 100 bis 1000 V eingestellt wird.

15. Verfahren nach einem der Ansprüche 11 bis 14, **dadurch gekennzeichnet, daß** das Arbeitsgas mit einem Volumenstrom von 10 bis 1000 Norm cm³/min eingestellt wird.

16. Verfahren nach einem der Ansprüche 11 bis 15, **dadurch gekennzeichnet, daß** für die Oberflächenmodifizierung die Potentialdifferenz zwischen Plasma und kastenförmigen Gebilde (1) auf kleiner als 200 V eingestellt und/oder der Druck um mindestens das Dreifache erhöht wird.

17. Verfahren nach einem der Ansprüche 11 bis 16, **dadurch gekennzeichnet, daß** im kastenförmigen Gebilde (1) eine Hohlkathoden-Glimmentladung ausgebildet wird.

18. Verfahren nach einem der Ansprüche 11 bis 17, **dadurch gekennzeichnet, daß** in das kastenförmige Gebilde (1) Inertgas, Reaktivgas oder ein Gemisch aus Inert- und Reaktivgas als Arbeitsgas zeitlich definiert eingeführt wird.

## Claims

1. Device for the plasma treatment of objects in a vacuum, in which
- a box-type structure (1) made of an electrically conductive material forms a vacuum chamber or can be introduced into a vacuum chamber;
- into which structure are placed, through at least one locking opening (8), objects (2) which are electrically insulated from the box-type structure (1) and which are enclosed all round by the box-type structure (1), into the box-type structure (1) at a distance from the internal walls;
- there is at least one opening (3) for the admittance, and at least one opening (4) for the removal, of working gas, together with an opening (6, 6') for the introduction of energy to generate a glow discharge;
- and the box-type structure (1) has an electrically negative potential towards the plasma which is generated with the glow discharge.

2. Device as in Claim 1,
**characterised in that**
an electrode (5) protrudes into the box-type structure (1) through an opening (6'), at which electrode a direct or alternating voltage for the generation of the plasma is fed in.

3. Device as in Claim 1,
**characterised in that**
microwaves for the generation of plasma are directed into the inside of the box-type structure through the opening (6).

4. Device as in one of Claims 1 to 3,
**characterised in that**
the objects (2) are charged with a predeterminable electrical potential.

5. Device as in one of Claims 1 to 4,
**characterised in that**
the internal walls of, or the box-type structure (1), are made of a coating material or are placed there in the form of a flat target.

6. Device as in one of Claims 1 to 5,
**characterised in that**
the box-type structure (1) is cooled.

7. Device as on one of Claims 1 to 6,
**characterised in that**
the internal width of the box-type structure (1) is at least 1.2 times the size of the objects (2), and the objects (2) occupy between 0.1 % and 30 % of the available space in the box-type structure (1 ).

8. Device as in one of Claims 1 to 7,
**characterised in that**
the size of the extraction opening (4) is greater than the total of the larger of the other openings (3, 6, 6') of the box-type structure (1).

9. Device as in one of Claims 1 to 8,
**characterised in that**
the box-type structure (1) or its inner surface are made of a metal, a metal alloy or a metal compound.

10. Method for the plasma treatment of the surfaces of objects with a device as in one of Claims 1 to 9,
**characterised in that**,
after evacuation to a sufficiently low pressure, and after a flushing process with a working gas in the box-type structure (1) made of an electrically conductive material, a plasma is generated, whereby the plasma output and the negative potential of the box-type structure (1) are set in such a manner that a modification of the surface and/or - by the stripping of material from the internal walls of the box-type structure (1) - a coating of the surface of the objects (2) that are enclosed all around by the box-type structure (1) are carried out.

11. Method as in Claim 10,
**characterised in that**,
prior to the modification or coating under the application of a negative potential at the box-type structure (1) and the ignition of a glow discharge, an ion-based desorption of deposited adsorbate layers is carried out.

12. Method as in Claim 10 or 11,
**characterised in that**
reactive gas is fed in during the coating process.

13. Method as in one of Claims 10 to 12,
**characterised in that**
particulate powder is fed into the box-type structure and/or is placed in readiness in a receptacle placed there, and the particulate powder is deposited on the surface (2) of the objects.

14. Method as in one of Claims 10 to 13,
**characterised in that**
the potential difference between the box-type structure (1) and the plasma is set to lie within the range of 100 to 1000 V.

15. Method as in one of Claims 11 to 14,
**characterised in that**
the working gas is set to have a volume flow of between 10 and 1000 norm cm³ / min.

16. Method as in one of Claims 11 to 15,
**characterised in that**,
for the modification of the surface, the potential difference between the plasma and the box-type structure (1) is set to be less than 200 V, and/or the pressure is increased at least threefold.

17. Method as in one of Claims 11 to 16,
**characterised in that**
a hollow cathode glow discharge is formed in the box-type structure (1).

18. Method as in one of Claims 11 to 17,
**characterised in that**
inert gas, reactive gas or a mixture of inert and reactive gas is fed, defined in time, into the box-type structure as the working gas.

## Revendications

1. Dispositif pour réaliser le traitement par plasma d'objets sous vide, dans lequel
- une structure en forme de boîte (1) réalisée en un matériau électriquement conducteur forme une chambre à vide ou peut être introduite dans une chambre à vide,
- des objets (2) isolés électriquement de la structure en forme de boîte (1) et entourés de tous côtés par la structure en forme de boîte (1) sont insérés par au moins une ouverture pouvant être fermée (8) dans la structure en forme de boîte (1) à une distance de la paroi intérieure;
- il est prévu au moins une ouverture (3) pour l'amenée et au moins une ouverture (4) pour l'évacuation d'un gaz de travail ainsi qu'une ouverture (6,6') pour l'introduction d'énergie pour la production d'une décharge à effluves; et
- la structure en forme de boîte (1) possède un potentiel électriquement négatif par rapport au plasma produit avec la décharge à effluves.

2. Dispositif selon la revendication 1, **caractérisé en ce qu'**une électrode (5), à laquelle est appliquée une tension continue ou alternative pour la production de plasma, pénètre par une ouverture (6') dans la structure en forme de boîte (1).

3. Dispositif selon la revendication 1, **caractérisé en ce que** des micro-ondes pour la production de plasma sont dirigées par l'ouverture (6) à l'intérieur de la structure en forme de boîte.

4. Dispositif selon l'une des revendications 1 à 4, **caractérisé en ce que** les objets (2) sont chargés par un potentiel électrique pouvant être prédéterminé.

5. Dispositif selon l'une des revendications 1 à 4, **caractérisé en ce que** la paroi intérieure de la structure en forme de boîte ou la structure en forme de boîte (1) est formée par un matériau de revêtement ou est disposée en cet endroit en tant que cible ayant une certaine surface.

6. Dispositif selon l'une des revendications 1 à 5, **caractérisé en ce que** la structure en forme de boîte (1) est refroidie.

7. Dispositif selon l'une des revendications 1 à 6, **caractérisé en ce que** la largeur intérieure de la structure en forme de boîte (1) est égale au moins à 1,2 fois la taille des objets (2), et les objets (2) remplissent l'espace disponible dans la structure en forme de boîte (1) avec un pourcentage allant de 0,1 % jusqu'à 30%.

8. Dispositif selon l'une des revendications 1 à 7, **caractérisé en ce que** la taille de l'ouverture d'aspiration (4) est supérieure à la somme des plus grandes des autres ouvertures (3, 6, 6') de la structure en forme de boîte (1).

9. Dispositif selon l'une des revendications 1 à 8, **caractérisé en ce que** la structure en forme de boîte (1) ou sa surface intérieure est constituée par un métal, un alliage métallique ou un pur composé métallique.

10. Procédé pour le traitement par plasma de surfaces d'objets, comportant un dispositif selon l'une des revendications 1 à 9,
**caractérisé en ce qu'**après un vidage à une pression suffisamment faible et un balayage avec un gaz inerte dans la structure en forme de boîte (1) constituée par un matériau électriquement conducteur, un plasma est formé, la puissance du plasma et le potentiel négatif de la structure en forme de boîte (1) étant réglés de telle sorte que moyennant une modification de la surface et/ou moyennant un enlèvement de matière à partir de la paroi intérieure de la structure en forme de boîte (1), on réalise un recouvrement de la surface des objets (2) entourés de tous côtés par la structure en forme de boîte (1).

11. Procédé selon la revendication 10, **caractérisé en ce qu'**avant la modification ou le recouvrement, alors qu'un potentiel négatif est appliqué à la structure en forme de boîte (1) et qu'une décharge à effluves est amorcée, on exécute une désorption, assistée par des ions, de couches déposées d'un adsorbat.

12. Procédé selon la revendication 10 ou 11, **caractérisé en ce qu'**un gaz réactif est envoyé pendant l'opération de recouvrement.

13. Procédé selon l'une des revendications 10 ou 11, **caractérisé en ce qu'**on envoie une poudre de substance solide dans la structure en forme de boîte et/ou on la prépare dans un récipient disposé dans cette structure et on dépose la poudre de substance solide sur la surface (2) des objets.

14. Procédé selon l'une des revendications 10 à 13, **caractérisé en ce qu'**on règle la différence de potentiels entre la structure en forme de boîte (1) et le plasma dans la gamme comprise entre 100 et 1000 V.

15. Procédé selon l'une des revendications 11 à 14, **caractérisé en ce que** le gaz de travail est réglé avec un débit volumique compris entre 10 et 1000 cm³/mn dans les conditions normales.

16. Procédé selon l'une des revendications 11 à 15, **caractérisé en ce que** pour la modification de la surface; on réalise un réglage préalable de la différence de potentiels entre le plasma et la structure en forme de boîte (1) sur une valeur inférieure à 200 V et/ou on accroît la pression au moins du triple.

17. Procédé selon l'une des revendications 11 à 16, **caractérisé en ce qu'**une décharge à effluves avec une cathode creuse est réalisée dans la structure en forme de boîte (1).

18. Procédé selon l'une des revendications 11 à 17, **caractérisé en ce qu'**un gaz inerte, un gaz réactif ou un mélange formé d'un gaz inerte et d'un gaz réactif est introduit d'une manière définie dans le temps, en tant que gaz de travail, dans la structure en forme de boîte (1).
